**Europäisches Patentamt**

**European Patent Office**

**Office européen des brevets**

(11) Veröffentlichungsnummer: **0 244 040**

**A2**

## (12) EUROPÄISCHE PATENTANMELDUNG

(21) Anmeldenummer: **87200800.8**

(22) Anmeldetag: **28.04.87**

(51) Int.Cl.³: **H 01 L 21/48**

(30) Priorität: **02.05.86 DE 3614810**

(43) Veröffentlichungstag der Anmeldung:
**04.11.87 Patentblatt 87/45**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**

(84) Benannte Vertragsstaaten:
**DE**

(71) Anmelder: **N.V. Philips' Gloeilampenfabrieken**
**Groenewoudseweg 1**
**NL-5621 BA Eindhoven(NL)**

(84) Benannte Vertragsstaaten:
**FR GB**

(72) Erfinder: **Vogel, Werner**
**Hochstrasse 164**
**D-4173 Kerken(DE)**

(72) Erfinder: **Schmitt-Thees, Michael**
**Goethestrasse 41**
**D-4156 Willich 1(DE)**

(74) Vertreter: **Kupfermann, Fritz-Joachim, Dipl.-Ing. et al,**
**Philips Patentverwaltung GmbH Wendenstrasse 35**
**Postfach 10 51 49**
**D-2000 Hamburg 1(DE)**

(54) Verfahren zum Trennen von kristallstrukturlosen Gegenständen, insbesondere Dickschichtsubstraten.

(57) Die Erfindung bezieht sich auf ein Verfahren zum Trennen von kristallstrukturlosen, plattenförmigen Gegenständen (1) längs einer linienförmigen, elektrisch aufheizbaren Hitzzone, die aus einer pastenförmigen, einer Verfestigungsbehandlung unterworfenen Materialbahn besteht, die unlösbar längs einer gewünschten Trennlinie auf der Oberfläche des zu trennenden Gegenstandes angebracht ist. Die Materialbahn wird zum Trennen von plattenförmigen Gegenständen aus Aluminiumoxyd, insbesondere Dickschichtsubstraten, aus einem elektrisch leitfähigen Material gebildet. Die so elektrisch leitfähig ausgebildete Trennleiterbahn (5, 15, 17, 33, 37) wird zum Trennen von elektrischem Strom druchflossen und dabei aufgeheizt.

FIG.1

EP 0 244 040 A2

0244040

BEZEICHNUNG GEÄNDERT
siehe Titelseite

1                    PHD 86-059 EP

Verfahren zum Trennen von kristallstrukturlosen
Gegenständen

Die Erfindung bezieht sich auf ein Verfahren zum Trennen
von kristallstrukturlosen, plattenförmigen Gegenständen
längs einer linienförmigen, elektrisch aufheizbaren
Hitzzone, die aus einer pastenförmigen, einer
Verfestigungsbehandlung unterworfenen Materialbahn
besteht, die unlösbar längs einer gewünschten Trennlinie
auf der Oberfläche des zu trennenden Gegenstandes
angebracht ist.

Zum Trennen von Glas ist es bekannt, längs einer gewünschten Trennstelle eines gerade nach dem Herstellen erkaltenden Gegenstandes durch Anlegen eines nassen Glasfadens
längs der Fadenanlegelinie ein Absprengen von Glasteilen
zu erzielen. Umgekehrt ist es möglich, von einem kalten
Glaskörper Teile abzusprengen, indem man längs eines
Teiles der gewünschten Trennlinie auf die Oberfläche des
Glases einen drahtförmigen Leiter aufdrückt, der dann
durch Anschließen an eine Stromquelle erhitzt wird (US-PS
41 13 162).

Bei der Bearbeitung von plattenförmigen Gegenständen, wie
Dickschichtsubstraten, ist es zum Trennen dieser Substrate bekannt, diese an der Oberfläche mit einem Laserstrahl anzuritzen und anschließend danach mechanisch zu brechen. Das anschließende mechanische Brechen erfordert einen zusätzlichen Handgriff. Weiterhin zeigt es sich, daß die Trennlinie abhängig ist von der Tiefe der vorherigen Ritzung und von der Struktur der Substratplatte.

Aus der US-PS 35 20 455 ist es bekannt, auf eine keramische Substratplatte in Strichform eine Bornitrat enthaltende Paste aufzutragen. Nach dem Abtrocknen der Paste wird der Strich dann mittels einer Flamme oder einer elektrischen Widerstandsheizung erhitzt, bis die Platte längs des Striches springt. Die Pastenreste werden nach dem Trennen durch Abwaschen entfernt. Dieses Trennverfahren ist umständlich, empfindlich und für Massenproduktion nicht geeignet.

Es ist Aufgabe der Erfindung, eine Trennverfahren der eingangs erwähnten Art zu schaffen, das einfach und auch im Rahmen einer Massenfertigung gut handhabbar ist und das keine später zu entfernenden Bearbeitungsrückstände, wie Niederschläge des beim Laser-Ritzen entstehenden Abbrandes, hinterläßt.

Die gestellte Aufgabe ist erfindungsgemäß dadurch gelöst, daß die Materialbahn zum Trennen von plattenförmigen Gegenständen aus Aluminiumoxyd, insbesondere Dickschichtsubstraten, aus einem elektrisch leitfähigen Material gebildet wird und daß die so elektrisch leitfähig ausgebildete Trennleiterbahn zum Trennen von elektrischem Strom durchflossen und dabei aufgeheizt wird.

Durch das Bilden der elektrischen Trennleiterbahn unmittelbar auf der Oberfläche des Gegenstandes und das Aufheizen der Trennleiterbahn mittels elektrischen Stromes wird ein Absprengvorgang erreicht, der relativ präzise längs einer gewünschten Trennlinie abläuft. Bei dem pastenförmigen Leitermaterial kann es sich um übliches Leiterbahnmaterial handeln, welches auch zum Bilden der übrigen Leiterbahnen auf Dickschichtsubstraten eingesetzt wird.

Nach einer weiteren Ausgestaltung der Erfindung ist deshalb vorgesehen, daß die Trennleiterbahn zugleich mit dem Aufbau von Schaltungsleitermustern aus pastenförmigem Leitermaterial auf der Oberfläche des Gegenstandes aufgebaut wird. Die Trennleiterbahn braucht also nicht gesondert angebracht zu werden; sie wird vielmehr im Zusammenhang mit der ohnehin notwendigen Bildung eines Schaltungsmusters auf der Dickschichtsubstratplatte angebracht. Der einzige Unterschied besteht darin, daß die Trennleiterbahnen im weiteren Herstellungsprozeß nicht in die Schaltungsstruktur der Dickschichtsubstratplatte eingebunden wird, sondern als Trennleiterbahnen zum Absprengen von Substratteilen dienen. Es ist zu beachten, daß die Form der gewünschten Trennlinie auch bei nicht-geradlinigem Verlauf der Form der Trennleiterbahn entspricht.

Nach einer weiteren Ausgestaltung der Erfindung ist vorgesehen, daß die Trennleiterbahn mäanderförmig ausgebildet wird, wobei an die jeweils zur gleichen Seite vorspringenden Trennleiterteile aus pastenförmigem Leitermaterial gebildete Kontaktflächen für Messerkontakte anschließen. Trennleiterbahn und Messerkontaktflächen lassen sich auf diese Weise sinnvoll miteinander kombinieren.

Nach einer weiteren Ausgestaltung der Erfindung ist vorgesehen, daß die Trennleiterbahn mit Glas abgedeckt wird. Durch eine solche Glasabdeckung wird das Kurzschließen zu anderen leitfähigen Teilen des Substrates vermieden. Dies gilt insbesondere dann, wenn das Substrat relativ dicht mit Schaltungsteilen bestückt ist.

Die Erfindung wird anhand der Zeichnung näher erläutert. Es zeigen:

Fig. 1 schematisch eine Dickschichtsubstratplatte mit einer aufgedruckten Trennleiterbahn sowie angesetzten Trennelektroden,

Fig. 2 durch Trennen längs der Trennleiterbahn nach Fig. 1 gebildete Substratteile,

Fig. 3 eine Substratplatte mit zwei verschiedenen Trennleiterbahnformen

Fig. 4 und 5 weitere Ausführungen von Trennleiterbahnen.

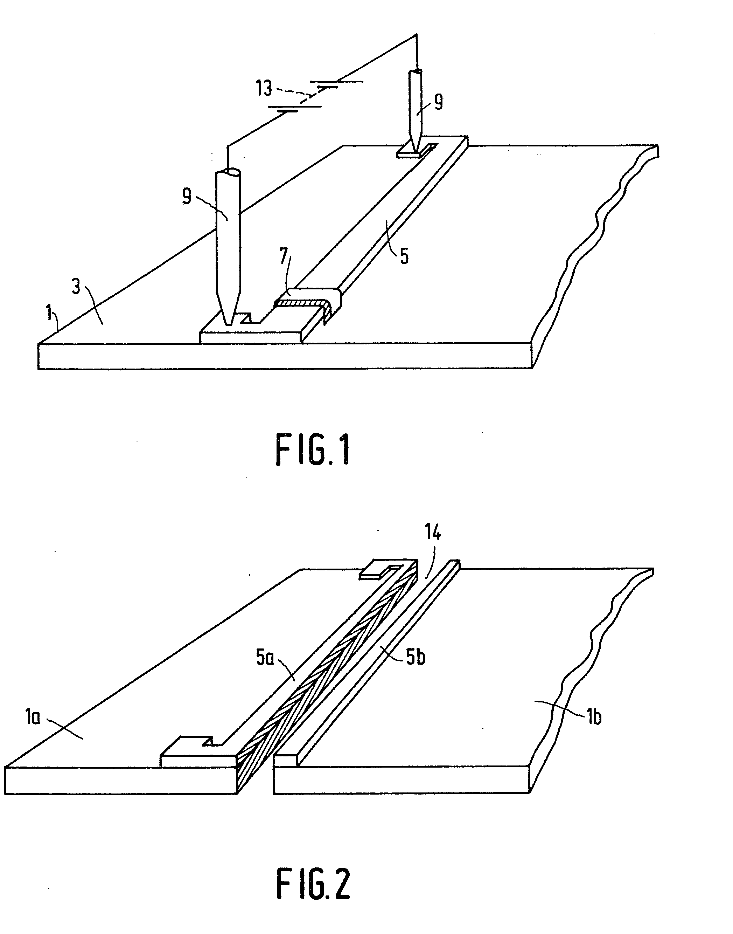

Die Darstellung nach Fig. 1 zeigt eine Dickschichtsubstratplatte 1 aus gesintertem Aluminiumoxyd (Al$_2$O$_3$).
Auf die Oberfläche 3 der Dickschichtsubstratplatte 1 ist
eine Trennleiterbahn 5 aufgedruckt und eingesintert. Das
Leitermaterial der Trennleiterbahn ist vor dem Aufdrucken
pastenförmig und wird in Pastenform auf die Oberfläche 3
auftragen. Dieser Auftrag kann entweder allein oder
zusammen mit anderen Leiterbahnen in einem Arbeitsgang
erfolgen. Die Trennleiterbahn kann beispielsweise eine
Breite von 0,2 bis 0,5 mm und eine Höhe von etwa 10 μm
aufweisen bei einer Substratplattendicke von
ca. 0,6-1 mm. Vorzugsweise ist die Trennleiterbahn 5 noch
abgedeckt mittels einer aufgesinterten Glasschicht 7,
falls Überschläge zu benachbarten Leiterbahnen oder
Bauteilen zu befürchten sind.

Zum Trennen werden auf Enden der Trennleiterbahn 5 Trennelektroden 9 aufgesetzt. Diese Trennelektroden werden an
eine Spannungsquelle 13 von beispielsweise 20 bis 40 V
gelegt. Dadurch heizt sich die Trennleiterbahn 5 auf, und
die Dickschichtsubstratplatte 1 zerspringt längs der
Trennleiterbahn 5 in zwei Teile 1a und 1b, wie es aus
Fig. 2 zu ersehen ist. Die Dickschichtsubstratplatte 1
wird vorzugsweise so gesprengt, daß auch die Trennleiterbahn 5 in zwei Teile 5a und 5b zerspringt.

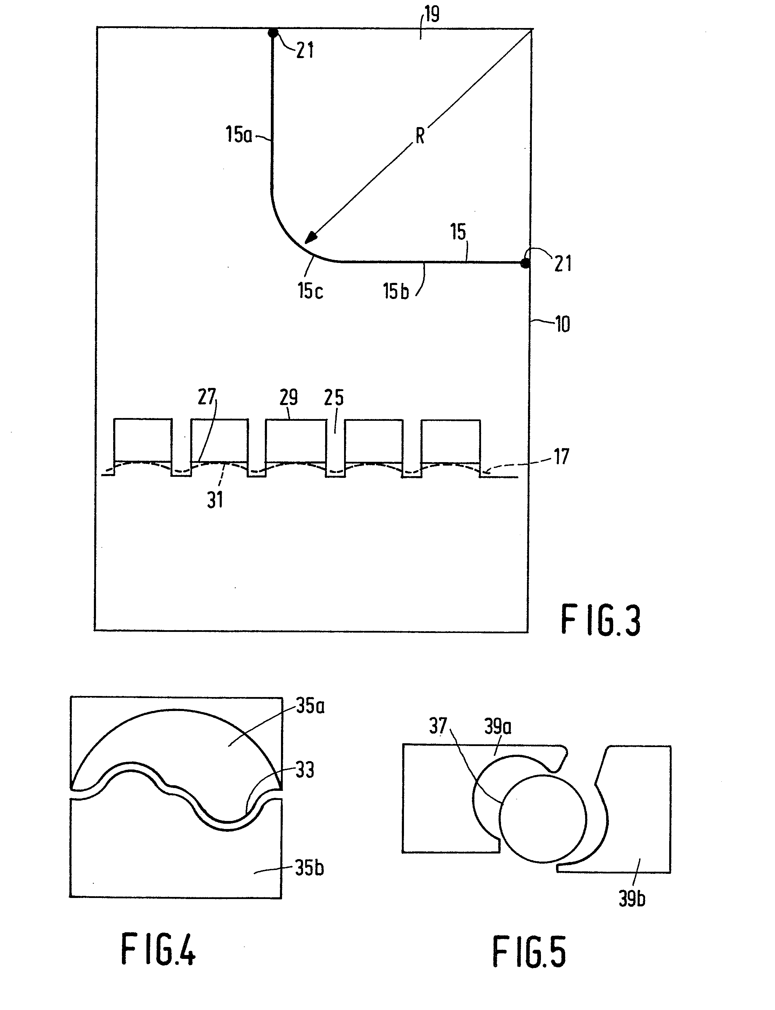

Fig. 3 zeigt eine Dickschichtsubstratplatte 10 mit zwei
anderen Ausführungsformen von Trennleiterbahnen 15 und
17. Die Trennleiterbahn 15 besteht aus zwei rechtwinkelig
zueinander verlaufenden Leiterbahnteilen 15a und 15b. Die Verbindung 15c zwischen beiden ist mit einem Radius R abgerundet. Der Grund dafür ist darin zu sehen, daß die Sprenglinie keinen eckigen Verlauf einnimmt. Die Abrundung ist soweit wie möglich an die erzielbare Spreng- oder Trennlinie angepaßt. Die Ausbildung in Fig. 3 oben dient dem Absprengen einer Ecke 19. Durch Anlegen einer Spannung an die Endpunkte 21 der winkelförmigen Leiterbahn 15 wird die Ecke 19 abgesprengt.

Bei der Ausführungsform der Trennleiterbahn 17 in Fig. 3 unten ist diese Trennleiterbahn 17 mäanderförmiger ausgebildet, wobei an jeweils zur gleichen Seite 25 vorspringende Trennleiterteile 27 aus pastenförmigem Leitermaterial gebildete Kontaktflächen 29 für Messerkontakt anschließen. Bei dieser Ausführungsform der Trennleiterbahn 17 ergibt sich eine Spreng- oder Trennlinie 31, die aus Fig. 3 zu ersehen ist.

Fig. 4 und 5 zeigen andere Trennleiterbahnformen. In Fig. 4 ist die Trennleiterbahn 33 gewellt. In der Zeichnung erfolgte bereits die Sprengung in zwei Substratteile 35a und 35b. Fig. 5 zeigt als anderes Ausführungsbeispiel eine kreisförmige Trennleiterbahn 37, längs der diese umgebenden Substratteile 39a, 39b abgesprengt wurden.

PATENTANSPRÜCHE:

1. Verfahren zum Trennen von kristallstrukturlosen, plattenförmigen Gegenständen (1) längs einer linienförmigen, elektrisch aufheizbaren Hitzzone, die aus einer pastenförmigen, einer Verfestigungsbehandlung unterworfenen Materialbahn besteht, die unlösbar längs einer gewünschten Trennlinie auf der Oberfläche des zu trennenden Gegenstandes angebracht ist, dadurch gekennzeichnet, daß die Materialbahn zum Trennen von plattenförmigen Gegenständen aus Aluminiumoxyd, insbesondere Dickschichtsubstraten, aus einem elektrisch leitfähigen Material gebildet wird und daß die so elektrisch leitfähig ausgebildete Trennleiterbahn (5, 15, 17, 33, 37) zum Trennen von elektrischem Strom durchflossen und dabei aufgeheizt wird.

2. Verfahren nach Anspruch 1, dadurch gekennzeichnet, daß die Trennleiterbahn (5, 15, 17, 33, 37) zugleich mit dem Aufbau von Schaltungsleitermustern aus pastenförmigem Leitermaterial auf der Oberfläche (3) des Gegenstandes (1) aufgebaut wird.

3. Verfahren nach den Ansprüchen 1 und/oder 2, dadurch gekennzeichnet, daß die Trennleiterbahnen (5, 15, 17, 33, 37) durch Sintern des pastenförmigen Leitermaterials gebildet wird.

4. Verfahren nach einem oder mehreren der Ansprüche 1 bis 3, <u>dadurch gekennzeichnet</u>, daß die Leiterbahn (17) mäanderförmig ausgebildet wird, wobei an die jeweils zur gleichen Seite (25) vorspringenden Trennleiterteile (27) aus pastenförmigem Leitermaterial gebildete Kontaktflächen (29) für Messerkontakte anschließen.

5. Verfahren nach einem oder mehreren der Ansprüche 1 bis 4, <u>dadurch gekennzeichnet</u>, daß die Trennleiterbahn (5, 15, 17) mit Glas (7) abgedeckt wird.

6. Verfahren nach einem oder mehreren der Ansprüche 1 bis 4, dadurch gekennzeichnet, daß die Trennleiterbahn (17) einen nicht-geradlinien Verlauf aufweist.

FIG.1

FIG.2

0244040

19

21

15a

R

15

15c    15b    21

10

27    29    25

17

31

**FIG.3**

35a

33

35b

**FIG.4**

37    39a

39b

**FIG.5**